# EUROPÄISCHE PATENTSCHRIFT

(11) **EP 1 437 038 B1**
(45) Veröffentlichungstag und Bekanntmachung des Hinweises auf die Patenterteilung: **12.01.2005**
(21) Anmeldenummer: 02774672.6
(22) Anmeldetag: 30.09.2002
(51) Int. Cl.: H05K 7/20, H02B 1/56

(54) **ABDICHTANORDNUNG**
SEALING ASSEMBLY
ENSEMBLE D'ETANCHEITE

(30) Priorität: 18.10.2001 DE 10151460
(43) Veröffentlichungstag der Anmeldung: 14.07.2004
(73) Patentinhaber: Knürr AG, 94424 Arnstorf (DE)
(72) Erfinder: BRETSCHNEIDER, Rainer, 01662 Meissen (DE); GALLASCH, Lars, 01665 Löthain (DE)
(74) Vertreter: Heim, Hans-Karl, Dipl.-Ing.
(86) Internationale Anmeldenummer: PCT/EP2002/010944
(87) Internationale Veröffentlichungsnummer: WO 2003/037055

(56) Entgegenhaltungen:
- DE-A- 19 531 310
- US-A- 5 184 879
- US-A- 5 657 641
- US-B1- 6 298 681

## Beschreibung

Die Erfindung betrifft eine Abdichtanordnung eines Gehäuses oder Geräteschrankes und eines anbaubaren klimatechnischen Gerätes.

Die Erfindung ist insbesondere für Gehäuse und Geräteschränke mit einem Aufnahmeraum für elektrische und elektronische Geräte und Bauteile geeignet, welche zur Abführung der von den Geräten und Bauteilen erzeugten Wärme und zur Einhaltung einer vorgebbaren Temperatur und damit zur Sicherung eines störungsfreien Betriebes der Geräte und Bauteile mit wenigstens einem klimatechnischen Gerät versehen werden können.

Als klimatechnische Geräte können Wärmetauscher, Kältemittel-Kühlgeräte, Peltierelemente und Lüfter, beispielsweise Filterlüfter, an- oder eingebaut werden. Der Anbau des wenigsten einen klimatechnischen Gerätes erfolgt in der Regel im Bereich eines Verkleidungsteils des Geräteschrankes, beispielsweise einer Tür, einer Seitenwand und/oder einer oberen Abdeckung, welche zu diesem Zweck mit entsprechenden Ausnehmungen zur Abführung der im Aufnahmeraum erwärmten Luft und zur Zuführung der gekühlten Luft versehen sind.

Insbesondere bei Geräteschränken der Telekommunikationstechnik, welche als Outdoorschränke im Freien mehr oder weniger ungeschützt den Umwelteinflüssen und Witterungsbedingungen ausgesetzt sind, besteht die Gefahr, dass Fremdkörper, Staub, insbesondere auch Wasser und Feuchtigkeit, durch einen nicht ausreichend abgedichteten Verbindungsbereich zwischen dem klimatechnischen Gerät und dem Verkleidungsteil des Gehäuses oder Geräteschrankes in einen Luftverteilungsraum eindringt und die Funktion der empfindlichen Geräte und Bauteile beeinträchtigt.

Hinsichtlich der Wasserbeständigkeit von Outdoor-Geräteschränken oder -Gehäusen wird herstellerseitig ein IP-Schutzwert von wenigstens X5 gefordert, d.h., die Geräteschränke, worunter nachfolgend immer auch Gehäuse verstanden werden sollen, sollen Strahlwasser, welches aus jeder Richtung auf den Geräteschrank gerichtet ist, standhalten. Bisher wurden beim Verschrauben oder sonstigem Verbinden klimatechnischer Geräte mit einem Verkleidungsteil eines Geräteschrankes Dichtungen mit einem unterschiedlichen Querschnitt, z.B. einem rechteckigen, halbrunden, runden Querschnitt oder Kombinationen davon, voll oder hohl, aus Gummi, Kautschuk, Kunststoffen oder Schäumen, auch ummantelt, flächig zusammengepresst. Dabei entstehen große Auflageflächen und damit verbunden hohe Anpresskräfte für eine Abdichtung, weshalb ohne weitere Schutzmaßnahmen nur die Schutzart IP X4 erreicht werden kann. Bei Ausbildung der notwendigen Ecken im Dichtungsverlauf entstehen zusätzliche Risiken für die Dichtheit bei geschnittenen Dichtungen im Eckstoß oder durch Aufwulstungen bei Eckausbildung durch Umbiegen von Dichtungsprofilen.

Aus der DE 195 31 310 C2 ist ein Schaltschrank mit einem in ein Wandelement eingebauten Wärmetauscher bekannt. Der Wärmetauscher ist als einstückiger Kühlkörper mit vertikalen, in den Schrankinnenraum ragenden Kühlrippen für einen Innenkreislauf und vertikalen, auf der Schrankaußenseite liegenden Außen-Kühlrippen ausgebildet. Eine Innen-Abdeckung für die Innenkühlrippen ist in einem oberen Bereich mit einem Abstand angeordnet. In diesem Bereich wird ein Innenventilator positioniert, welcher die Luft aus dem Schrankinnenraum ansaugt und durch die Innen-Kanäle nach unten und über Luftaustrittsdüsen oder Luftkanäle, welche in einer Auslassplatte, der Innenabdeckung angeordnet sind, in den Schrankinnenraum zurückführt. Fakultativ können die Außen-Kanäle durch eine Außenabdeckung abgedeckt werden. Die Befestigung des einstückigen Kühlkörpers des Wärmetauschers erfolgt im Bereich von Seitenwänden punktförmig an Vertikalprofilen des Schrankes.

In der US 61 64 369 ist ein Outdoor-Schrank beschrieben, welcher wenigsten eine als Wärmetauscher ausgebildete Tür aufweist. Die Tür liegt in Schließstellung mit einer Innenfläche an schrankseitig angeordneten Dichtungen an. Mit Abstand zu dem innenseitigen Türblatt ist eine Abdeckung montiert, welche in einem oberen Bereich eine Luftdurchtrittsöffnung aufweist. Das innenseitige Türblatt ist in einem unteren Bereich mit einer Luftdurchtrittsöffnung versehen, welche mit einer weiteren, schrankseitig angeordneten Öffnung in einer unteren Kammer, in welcher insbesondere Batterien angeordnet werden, zusammenwirkt. Wenigstens ein Ventilator im Bereich der Luftdurchtrittsöffnung des Türblatts bewirkt eine Luftströmung durch die untere Kammer und die doppelwandige Tür, so dass ein Wärmeübergang bzw. eine Abkühlung der oberen Kammer und der darin angeordneten elektrischen Geräte erreicht wird.

Der Erfindung liegt die **Aufgabe** zugrunde, eine Abdichtanordnung zu schaffen, welche beim Anbau eines klimatechnischen Gerätes an einen Geräteschrank die erforderliche Abdichtung, wenigstens eine Abdichtung gegen Strahlwasser aus einer Düse aus allen Richtungen nach IP X5, gewährleistet.

Erfindungsgemäß wird die Aufgabe durch die Merkmale des Anspruchs 1 gelöst. Zweckmäßige und vorteilhafte Ausgestaltungen sind in den Unteransprüchen und in der Figurenbeschreibung enthalten.

Ein Grundgedanke der Erfindung kann darin gesehen werden, eine wasserdichte linienförmige Abdichtung des Verbindungsbereiches zwischen dem klimatechnischen Gerät und dem jeweiligen Verkleidungsteil eines Geräteschrankes mit Hilfe wenigstens eines Dichtrahmens und einer zugehörigen elastischen Dichtung zu erreichen.

Erfindungsgemäß kann ein Dichtrahmen an dem klimatechnischen Gerät, sinnvollerweise an einem zur Anlage bzw. zur Verbindung mit dem Verkleidungsteil des Geräteschrankes vorgesehenen Befestigungsteil, welches in aller Regel ein Gehäuseteil, beispielsweise eines Wärmetauschers ist, angeordnet sein. Alternativ besteht auch die Möglichkeit, das Verkleidungsteil des Geräteschrankes, beispielsweise eine Tür, mit einem Dichtrahmen zu versehen, welcher mit einer entsprechenden elastischen Dichtung am Dichtrahmen oder an dem klimatechnischen Gerät zusammenwirkt. Der Dichtrahmen kann rechteckig, vieleckig, rund oder aus kombinierten Formelementen bestehend ausgeführt sein.

In einer besonders bevorzugten Ausbildung ist ein Dichtrahmen sowohl an dem klimatechnischen Gerät als auch an dem Verkleidungsteil des Geräteschrankes angeordnet, welche mit elastischen Dichtungen eine ununterbrochene, linienförmige und ausreichend starke örtliche Kompression der Dichtungen gewährleistet, wenn das klimatechnische Gerät mit dem Verkleidungsteil oder auch einem anderen Gehäusebauteil des Geräteschrankes verbunden wird.

Wesentlich ist die linienförmige Berührung durch die Ausbildung des wenigstens einen Dichtrahmens an dem entsprechenden Befestigungsteil des klimatechnischen Gerätes und/oder des Verkleidungsteiles des Geräteschrankes.

Eine wasserdichte Verbindung der IP-Schutzart X5 wird ebenfalls dann erreicht, wenn zusätzlich im Bereich der Luftzufuhrund/oder Luftabführungsöffnungen des Verkleidungsteils eine Abdeckung vorgesehen ist. Diese Abdeckung ist vorteilhaft zwischen dem Befestigungsteil des klimatechnischen Gerätes und dem Verkleidungsteil des Geräteschrankes angeordnet und weist im Bereich der Luftverteilungsräume zur Luftzufuhr bzw. Luftabführungen Perforationen auf. Zur endlosen Abdichtung der Luftverteilungsräume liegen der Dichtrahmen des Befestigungsteils des klimatechnischen Gerätes und der Dichtrahmen des Verkleidungsteils jeweils randseitig über die zugehörige Dichtung an der Abdeckung an. Dadurch wird vorteilhafterweise auf beiden Seiten der Abdeckung eine linienförmige Abdichtung erreicht und eine den Anforderungen entsprechende Abdichtung gegen Feuchtigkeit gewährleistet.

Ein Luftverteilungsraum bildet sich jedoch auch aus, wenn die Dichtkante und die Dichtung selbst einen Abstand zwischen Verkleidungsteil und klimatechnischem Gerät erzeugen, ohne dass Abdeckungen dazwischen angeordnet werden. Im einfachsten Fall verlaufen Dichtung und Dichtrahmen parallel zu den Begrenzungslinien der Luftein- und Austrittsbereiche.

Ein weiterer Vorteil der Abdeckung, welche zweckmäßigerweise an dem Verkleidungsteil lösbar befestigt werden kann, ist die Ausbildung als ein Bauteil zur EMV-Abschirmung der im Geräteschrank aufgenommenen Geräte und Bauteile. Es besteht auch die Möglichkeit, die Abdeckung randseitig mit EMV-Federelementen zu versehen, um eine elektrische Verbindung zu dem Verkleidungsteil und/oder dem klimatechnischen Gerät herzustellen.

Die Dichtrahmen stehen rechtwinklig von dem Befestigungsteil des klimatechnischen Gerätes bzw. von dem Verkleidungsteil des Geräteschrankes ab und eine Dichtkante am freien Ende reicht bis zu der zugehörigen Dichtung, welche an der Innen- bzw. Außenseite der Abdeckung angeordnet sein kann. Alternativ kann ein Dichtungsstrang, beispielsweise eine Lippendichtung, auch im Bereich der Dichtkante eines oder beider Dichtrahmen angeordnet werden und abdichtend an der Abdeckung anliegen. Der Dichtrahmen kann im Bereich der Dichtkante eine Nut zur Aufnahme und Halterung eines Dichtungsprofils aufweisen.

Es besteht jedoch auch die Möglichkeit, die Abdeckung zur Aufnahme eines Dichtungsprofils auszubilden oder eine Schaumdichtung, beispielsweise einen zweikomponentigen Polyurethanschaum, aufzubringen. Eine derartige Dichtung kann vorteilhafterweise zur EMV-Abschirmung ausgebildet sein und z.B. Metallpartikel enthalten.

Zweckmäßigerweise sind Befestigungsholme zur Befestigung der Abdeckung vorgesehen, welche lösbar an dem Verkleidungsteil angeordnet werden können. In diese Befestigungsholme, welche vertikal und horizontal zu einem umlaufenden Rahmen angeordnet sind, kann der Dichtrahmen des Verkleidungsteils integriert sein. Besonders zweckmäßig ist es, dass an den Befestigungsholmen auch das klimatechnische Gerät, beispielsweise mit Hilfe eines Befestigungsrahmens befestigt werden kann. Mit einem entsprechend dimensionierten und am klimatechnischen Gerät angeordneten Dichtrahmen ist dann mit der Befestigung die erforderliche linienförmige Abdichtung realisierbar.

Grundsätzlich kann der Dichtrahmen des klimatechnischen Gerätes in die Fertigung, beispielsweise des Befestigungsteils, integriert sein. Eine Integration des Formelementes in Urformteile ist besonders bei Kunststoffspritz- oder -pressteilen sowie bei Metallgussteilen oder Strangpressprofilen vorteilhaft.

Alternativ kann der Dichtrahmen des Befestigungsteils des klimatechnischen Gerätes auch als winkelförmiger Dichtrahmen ausgebildet sein, welcher mit einem Befestigungsschenkel an dem Befestigungsteil anliegt und beispielsweise durch Punktschweißen befestigt und nachfolgend abgedichtet wird.

Die Befestigung des klimatechnischen Gerätes erfolgt mit einem Befestigungsrahmen, welcher zweckmäßigerweise einen Befestigungsflansch aufweist, der parallel zur Abdeckung verläuft und zusammen mit der Abdeckung am jeweiligen Befestigungsholm des Verkleidungsteils fixiert werden kann.

Indem das klimatechnische Gerät im Bereich seines Befestigungsteils mit einem Dichtrahmen versehen wird, dessen linienförmige Dichtkante mit einer elastischen Dichtung, inbesondere auf einer Außenfläche einer Abdeckung, zusammenwirkt, kann ein klimatechnisches Gerät problemlos vor Ort an ein Verkleidungsteil eines Geräteschrankes oder eines Gehäuses angebaut und auch ausgewechselt werden, wobei jeweils die erforderliche wasserdichte Verbindung erreicht wird.

Die Erfindung wird nachstehend anhand einer Zeichnung weiter erläutert; in dieser zeigen in einer stark schematisierten Darstellung
- Fig. 1: einen Geräteschrank mit klimatechnischen Geräten im Bereich der Türen;
- Fig. 2: eine Explosionszeichnung einer zum Anbau eines klimatechnischen Gerätes ausgebildeten Tür eines Geräteschrankes;
- Fig. 3: die Tür nach Fig. 2, jedoch ohne Abdeckung;
- Fig. 4: einen Querschnitt durch eine Tür eines Geräteschrankes mit angebautem klimatechnischen Gerät;
- Fig. 5: eine Ansicht der Innenseite einer Türabdeckung;
- Fig. 6: eine Ansicht der Außenseite der Türabdeckung nach Fig. 5;
- Fig. 7: eine Draufsicht auf ein klimatechnisches Gerät mit Befestigungsteil;
- Fig. 8: einen Querschnitt nach Linie VIII-VIII der Fig. 7 und
- Fig. 9: einen vergrößerten Ausschnitt des Befestigungsteils nach Fig. 7.

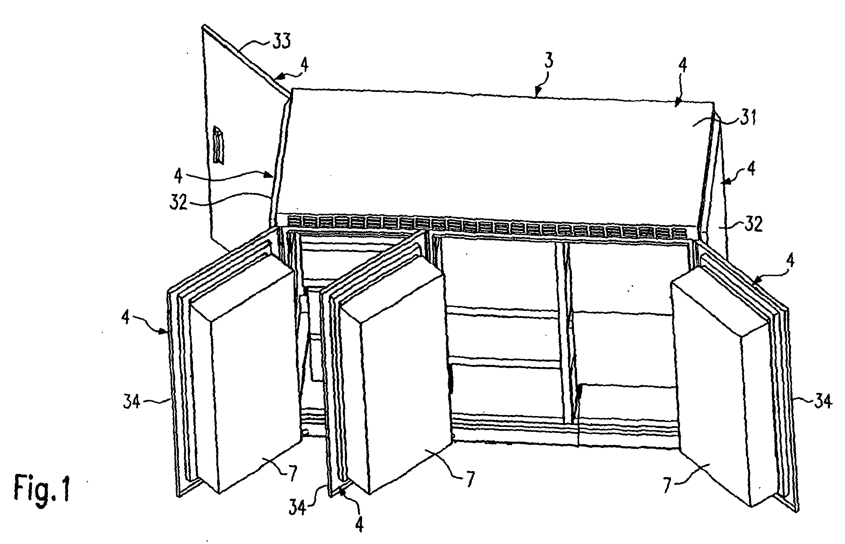

Figur 1 zeigt einen Geräteschrank 3 für den Außenbereich mit einer wasserdichten oberen Abdeckung 31, zwei Seitenwänden 32, rückseitigen Türen 33, von denen eine Tür 33 geöffnet ist, und drei Fronttüren 34 als Verkleidungsteile 4. Die Fronttüren 34 sind in Offenstellung gezeigt und weisen jeweils einen Wärmetauscher als klimatechnisches Gerät 7 auf, welche jedoch nur schematisch und ohne Luftdurchgangsöffnungen gezeigt sind.

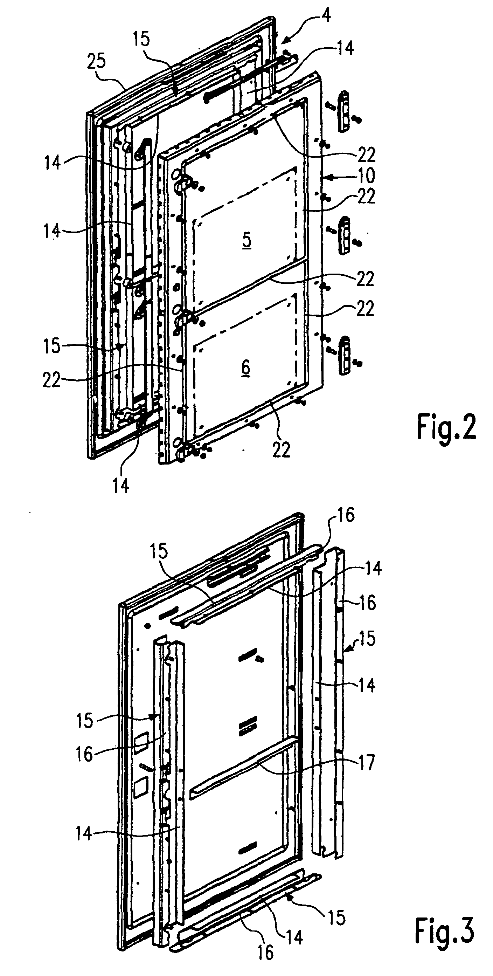

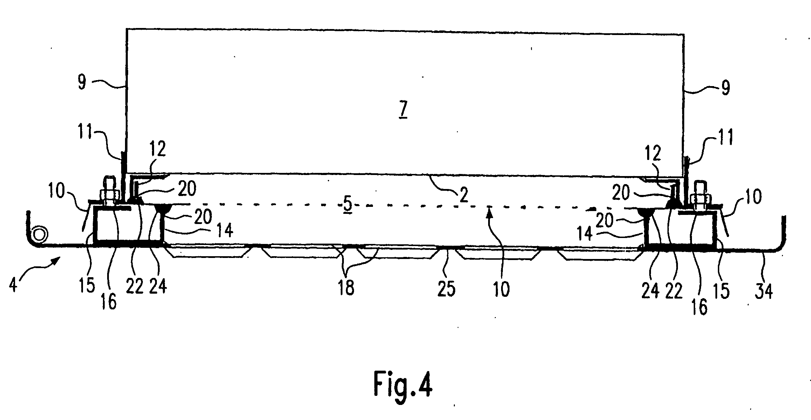

In Figur 2 ist als Verkleidungsteil 4 eine Tür gezeigt, welche zum Anbau eines klimatechnischen Gerätes (nicht dargestellt) ausgebildet ist. Die Tür 4 weist ein Türblatt 25 auf, an welchem ein Dichtrahmen 14 endlos umlaufend befestigt ist. Der Dichtrahmen 14 ist in diesem Ausführungsbeispiel in Befestigungholme 15, welche im Einzelnen aus der Figur 3 hervorgehen, integriert und senkrecht zu dem Türblatt 25 in Richtung einer Abdeckung 10 ausgerichtet. Der Dichtrahmen 14 bildet einen Schenkel der U-förmig ausgebildeten, vertikal und horizontal angeordneten Befestigungsholme 15. An dem jeweils äußeren zweiten Schenkel der U-förmigen Befestigungsholme ist zusätzlich ein Befestigungsflansch 16 ausgebildet, welcher parallel zu dem Türblatt 25 verläuft und der Befestigung der Abdeckung 10 (Fig. 2 und 4) sowie des klimatechnischen Gerätes 7 (Fig. 4) dient.

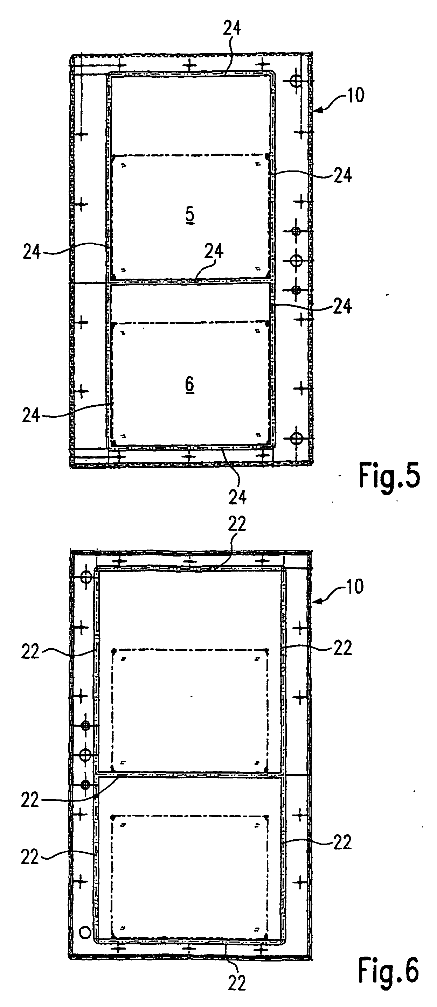

In Figur 2 ist ein oberer Luftverteilungsraum 5 und ein unterer Luftverteilungsraum 6 strichliert an der Abdeckung 10 angedeutet. Innerhalb der Luftverteilungsräume 5, 6 ist die Abdeckung 10 luftdurchlässig und beispielsweise perforiert ausgebildet (nicht dargestellt), um eine Luftzufuhr sowie eine Luftabführung in bzw. aus dem Aufnahmeraum (nicht dargestellt) zu ermöglichen. Der Dichtrahmen 14 weist zur Abdichtung der zwei Luftverteilungsräume 5, 6 einen horizontal angeordneten Dichtwinkel 17 auf, welcher die zwei vertikal ausgerichteten Dichtrahmen 14 verbindet und mit einer komplementären Dichtung 24 auf der Innenseite der Abdeckung 10 (siehe Fig. 5) zusammenwirkt.

Auf der Außenseite der Abdeckung 10 nach Figur 2 ist eine Dichtung 22 aufgebracht, deren Anordnung dem Dichtrahmen 12 auf dem anzubauenden klimatechnischen Gerät (nicht dargestellt) entspricht, um eine linienförmige, wasserdichte Abdichtung zu erreichen (siehe auch Fig. 4 und 6).

Figur 4 zeigt eine bevorzugte Abdichtanordnung eines Geräteschrankes, von welchem als Verkleidungsteil 4 eine Tür gezeigt ist. Im Bereich von Luftdurchtrittsöffnungen 18 des Türblatts 25, die im Beispiel als Kiemen ausgebildet sind, ist an der Innenseite ein klimatechnisches Gerät 7 angebaut. Zwischen dem klimatechnischen Gerät 7 und dem Verkleidungsteil 4 ist eine Abdeckung 10 angeordnet, welche parallel zu dem Türblatt 25 des Verkleidungsteils 4 verläuft und im Bereich der Luftverteilungsräume 5,6, von denen der Luftverteilungsraum 5 gezeigt ist, luftdurchlässig ist. Mit Hilfe der Abdeckung 10, eines Dichtrahmens 12 am klimatechnischen Gerät 7 und eines Dichtrahmens 14 am Verkleidungsteil 4 sowie mit den Dichtrahmen 12, 14 zusammenwirkenden Dichtungen 22, 24 wird eine wasserdichte, linienförmige Abdichtung der Luftverteilungsräume 5,.6 und der erforderliche IP-Schutzgrad X5 gewährleistet.

Im vorliegenden Ausführungsbeispiel sind die Dichtungen 22, 24 auf der Innenseite und Außenseite der Abdeckung 10 als ein zweikomponentiger Polyurethanschaum aufgeschäumt und werden von Dichtkanten 20 an den Dichtrahmen 12, 14 nach Befestigung des klimatechnischen Gerätes 7 an dem Verkleidungsteil 4 über die ganze Länge der Dichtkante 20 komprimiert. Dadurch wird eine dauerhafte Abdichtung erreicht, welche den Anforderungen der Anwender der Geräteschränke und Gehäuse entspricht.

Figur 4 zeigt auch die Ausbildung der Befestigungsholme 15 an der Innenseite des Verkleidungsteils 4, in welche innenseitig der Dichtrahmen 14 mit Dichtkante 20 integriert ist. Die Befestigungsholme 15 mit Dichtrahmen 14 sind im Querschnitt etwa U-förmig ausgebildet und mit einem rechtwinklig nach innen abgebogenen Befestigungsflansch 16 versehen. Im Bereich des Befestigungsflansches 16 erfolgt die Befestigung der Abdeckung 10 sowie des klimatechnischen Gerätes 7 mit Hilfe eines Befestigungsrahmens 11, welcher an den vier Seitenwänden 9 des klimatechnischen Gerätes 7 angeordnet ist. Randseitig an einem Befestigungsteil 2 des klimatechnischen Gerätes 7 und mit der zugehörigen Dichtung 22 auf der Abdeckung 10 zusammenwirkend, ist der Dichtrahmen 12 des klimatechnischen Gerätes 7 befestigt. Figur 4 verdeutlicht die zweifache linienförmige Abdichtung auf der Innen- und Außenseite der zusätzlichen Abdeckung 10 zwischen dem klimatechnischen Geräte 2 und dem Verkleidungsteil 4, welche zu einer verbesserten Abdichtung gegen Wasser, insbesondere der IP-Schutzart X5 oder höher bzw. vergleichbarer Anforderungen aus internationalen Normen, führt.

In den Figuren 5 und 6 ist eine Abdeckung 10 mit Sicht auf die Innenseite und die hier aufgebrachte Dichtung 24 (Figur 5) und auf die Außenseite und die hier aufgebrachte Dichtung 22 gezeigt (Fig. 6). Analog zur Figur 2 sind die Luftverteilungsräume 5, 6 strichpunktiert angedeutet. In diesem Bereich der Luftverteilungsräume 5, 6 ist die Abdeckung 10 zur Luftzufuhr bzw. Luftabfuhr ausgebildet und z.B. mit Perforationen versehen (nicht dargestellt). Die Dichtungen 22, 24 sind komplementär zu den Dichtrahmen 12, 14 angeordnet und begrenzen die Luftverteilungsräume 5, 6 unter einer linienförmigen Abdichtung.

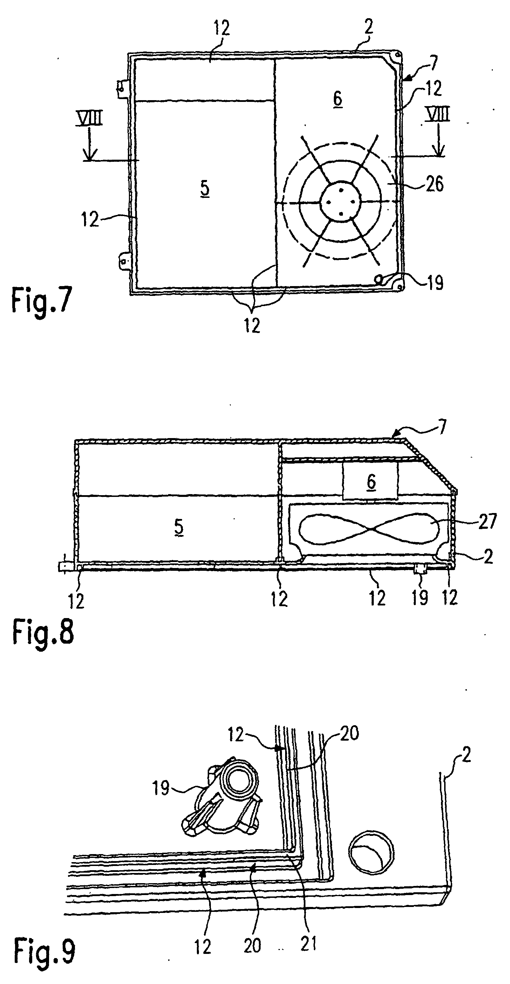

Die Figuren 7 bis 9 zeigen ein weiteres Ausführungsbeispiel für ein anbaubares klimatechnisches Gerät 7. In diesem Beispiel ist der Dichtrahmen in das Kunststoffgehäuse des klimatechnischen Gerätes konstruktiv und stofflich integriert. In Figur 7 ist das Befestigungsteil 2 mit einem Dichtrahmen 12 zu erkennen, welcher zur Abdichtung eines linken und rechten Luftverteilungsraums 5, 6 randseitig und mittig ausgebildet ist. Im Bereich des rechten Luftverteilungsraums 6 ist ein Abdeckgitter 26 eines Lüfters 27 (siehe Figur 8) angeordnet und in einem unteren Bereich eine Austragsöffnung 19 für angesammeltes Wasser ausgebildet (siehe auch Figur 9). Die integrierte Ausbildung des Dichtrahmens 12 ist insbesondere aus der Querschnittsdarstellung der Figur 8 sowie aus der vergrößerten ausschnittsweisen Darstellung nach Figur 9 erkennbar. Der Dichtrahmen 12 mit Dichtkante 20 und Nut 21 kann einen Dichtungsstrang (nicht dargestellt) aufnehmen.

## Patentansprüche

1. Abdichtanordnung eines Gehäuses oder Geräteschrankes (3) und eines anbaubaren klimatechnischen Gerätes (7), wobei das klimatechnische Gerät (7) mit einem Befestigungsteil (2) an ein Verkleidungsteil (4) des Gehäuses oder Geräteschrankes (3) fixierbar und wenigstens ein Luftverteilungsraum (5, 6) abdichtbar ist,
**dadurch gekennzeichnet,**
**dass** eine wasserdichte linienförmige Abdichtung des Luftverteilungsraumes (5, 6) vorgesehen ist und dass wenigstens ein Dichtrahmen (12, 14) an dem Befestigungsteil (2) des klimatechnischen Gerätes (7) und/oder an dem Verkleidungsteil (4) des Gehäuses oder des Geräteschrankes (3) angeordnet ist und mit einer Dichtung (22, 24) zusammenwirkt.

2. Abdichtanordnung nach Anspruch 1,
**dadurch gekennzeichnet,**
**dass** wenigstens im Bereich des oder der Luftverteilungsräume (5, 6) eine Abdeckung (10) vorgesehen ist, welche zwischen dem Befestigungsteil (2) des klimatechnischen Gerätes (7) und dem Verkleidungsteil (4) des Gehäuses oder Geräteschrankes (3) angeordnet ist, und dass die Dichtrahmen (12, 14) und die Dichtungen (22, 24) zur Anlage an der Abdeckung (10) ausgebildet sind.

3. Abdichtanordnung nach Anspruch 2,
**dadurch gekennzeichnet,**
**dass** die Abdeckung (10) an dem Verkleidungsteil (4) lösbar befestigt ist.

4. Abdichtanordnung nach Anspruch 2 oder 3,
**dadurch gekennzeichnet,**
**dass** die Abdeckung (10) im Bereich der Luftverteilungsräume (5, 6) perforiert ausgebildet ist.

5. Abdichtanordnung nach einem der Ansprüche 2 bis 4,
**dadurch gekennzeichnet,**
**dass** die Abdeckung (10) als Bauteil zur elektromagnetischen Abschirmung ausgebildet und/oder mit EMV-Dichtungselementen versehen ist.

6. Abdichtanordnung nach einem der Ansprüche 2 bis 3,
**dadurch gekennzeichnet,**
**dass** die Abdeckung (10) an Befestigungsholmen (15), welche vertikal und horizontal an dem Verkleidungsteil (4) angeordnet sind, fixierbar ist.

7. Abdichtanordnung nach einem der vorhergehenden Ansprüche,
**dadurch gekennzeichnet,**
**dass** die Dichtrahmen (12, 14) nahezu rechtwinklig von dem Befestigungsteil (2) bzw. dem Verkleidungsteil (4) abstehen und eine Dichtkante (20) aufweisen, welche nahezu bis an die Abdeckung (10) reicht.

8. Abdichtanordnung nach Anspruch 7,
**dadurch gekennzeichnet,**
**dass** die Dichtungen (22, 24) auf den Dichtrahmen (12, 14) oder komplementär zu den Dichtrahmen (12, 14) auf der Innen- bzw. Außenseite der Abdeckung (10) aufgebracht sind.

9. Abdichtanordnung nach Anspruch 8,
**dadurch gekennzeichnet,**
**dass** die Dichtungen (22, 24) Dichtungsprofile, beispielsweise Lippendichtungen sind, welche lösbar an den Dichtrahmen (12, 14) oder an der Abdeckung (10) gehalten sind.

10. Abdichtanordnung nach Anspruch 8,
**dadurch gekennzeichnet,**
**dass** als Dichtungen (22, 24) geschäumtes Polyurethan direkt auf der Abdeckung (10) durch Extrusion aufgebracht und nach Abschluss eines Schäumvorgangs eine Endlosdichtung gebildet ist.

11. Abdichtanordnung nach einem der Ansprüche 6 bis 10,
**dadurch gekennzeichnet,**
**dass** die Befestigungsholme (15) des Verkleidungsteils (4) im Querschnitt U-förmig ausgebildet sind und der Dichtrahmen (14) in die Befestigungsholme (15) integriert ist.

12. Abdichtanordnung nach Anspruch 11,
**dadurch gekennzeichnet,**
**dass** die Befestigungsholme (15) außenseitig einen Befestigungsflansch (16) aufweisen, welcher parallel zu dem Türblatt (25) und zur Abdeckung (10) verläuft und dass die Abdeckung (10) sowie das klimatechnische Gerät (7) an dem Befestigungsflansch (16) fixierbar sind.

13. Abdichtanordnung nach Anspruch 12,
**dadurch gekennzeichnet,**
**dass** das klimatechnische Gerät (7) mit Hilfe eines Befestigungsrahmens (11) an den Befestigungsholmen (15) des Verkleidungsteiles (4) fixierbar ist.

14. Abdichtanordnung nach einem der vorhergehenden Ansprüche,
**dadurch gekennzeichnet,**
**dass** der Dichtrahmen (12) in das Befestigungsteil (2) des klimatechnischen Gerätes (7) integriert ist.

## Claims

1. Sealing arrangement of an enclosure or equipment cabinet (3) and an attachable air conditioning device (7), the air conditioning device (7) being fixable with a fixing part (2) to a covering part (4) of the enclosure or equipment cabinet (3) and at least one air distribution space (5, 6) can be sealed,
**characterized in that**
a watertight, linear sealing of the air distribution space (5, 6) is provided and
that at least one sealing frame (12, 14) is located on the fixing part (2) of the air conditioning device (7) and/or on the covering part (4) of the enclosure or equipment cabinet (3) and cooperates with a seal (22, 24).

2. Sealing arrangement according to claim 1,
**characterized in that**
a cover (10) is provided at least in the vicinity of the air distribution space or spaces (5, 6) and is positioned between the fixing part (2) of the air conditioning device (7) and the covering part (4) of the enclosure or equipment cabinet (3), and that the sealing frames (12, 14) and seals (22, 24) are constructed for engagement on the cover (10).

3. Sealing arrangement according to claim 2,
**characterized in that**
the cover (10) is detachably fixed to the covering part (4).

4. Sealing arrangement according to claim 2 or 3,
**characterized in that**
the cover (10) is perforated in the vicinity of the air distribution spaces (5, 6).

5. Sealing arrangement according to one of the claims 2 to 4,
**characterized in that**
the cover (10) is constructed as a component for electromagnetic shielding purposes and/or is provided with EMC sealing elements.

6. Sealing arrangement according to one of the claims 2 or 3,
**characterized in that**
the cover (10) can be fixed to fixing struts (15), which are arranged vertically and horizontally on the covering part (4).

7. Sealing arrangement according to one of the preceding claims,
**characterized in that**
the sealing frames (12, 14) project almost at right angles from the fixing part (2) or covering part (4) and have a sealing edge (20) extending almost up to the cover (10).

8. Sealing arrangement according to claim 7,
**characterized in that**
the seals (22, 24) are fitted to the sealing frames (12, 14) or in complementary manner to said sealing frames (12, 14) on the inside or outside of the cover (10).

9. Sealing arrangement according to claim 8,
**characterized in that**
the seals (22, 24) are sealing profiles, e.g. lip-type seals, which are detachably held on the sealing frames (12, 14) or on the cover (10).

10. Sealing arrangement according to claim 8,
**characterized in that**
as seals (22, 24) foamed polyurethane is directly applied by extrusion to the cover (10) and following a foaming process a continuous seal is formed.

11. Sealing arrangement according to one of the claims 6 to 10, **characterized in that**
the fixing struts (15) of the covering part (4) are cross-sectionally U-shaped and the sealing frame (14) is integrated into the fixing struts (15).

12. Sealing arrangement according to claim 11,
**characterized in that**
externally the fixing struts (15) have a fixing flange (16) running parallel to the door leaf (25) and to the cover (10) and that the cover (10) and air conditioning device (7) can be fixed to the fixing flange (16).

13. Sealing arrangement according to claim 12,
**characterized in that**
the air conditioning device (7) can be fixed with the aid of a fixing frame (11) to the fixing struts (15) of the covering part (4).

14. Sealing arrangement according to one of the preceding claims,
**characterized in that**
the sealing frame (12) is integrated into the fixing part (2) of the air conditioning device (7).

## Revendications

1. Ensemble d'étanchéité d'un boîtier ou d'une armoire (3) à instruments et d'un appareil de climatisation rapportable (7), l'appareil de climatisation (7) pouvant être fixé avec une partie (2) de fixation à une partie d'habillage (4) du boîtier ou de l'armoire (3) à instruments et au moins une chambre (5, 6) de répartition d'air pouvant être fermée hermétiquement,
***caractérisé en ce qu***'une étanchéité linéaire imperméable à l'eau de la chambre (5, 6) de répartition d'air est prévue, et
***en ce qu***'au moins un cadre d'étanchéité (12, 14) est placé sur la partie (2) de fixation de l'appareil de climatisation (7) et/ou sur la partie (4) d'habillage du boîtier ou de l'armoire (3) à instruments et coopère avec un joint (22, 24).

2. Ensemble d'étanchéité selon la revendication 1,
***caractérisé en ce qu***'au moins au niveau du ou des chambres (5, 6) de répartition d'air, il est prévu une fermeture (10) qui est placée entre la partie (2) de fixation de l'armoire (7) de climatisation et la partie d'habillage (4) du boîtier ou de l'armoire (3) à instruments, et
***en ce que*** le cadre d'étanchéité (12, 14) et les joints (22, 24) sont conformés pour 'appuyer contre la fermeture (10).

3. Ensemble d'étanchéité selon la revendication 2,
***caractérisé en ce que*** la fermeture (10) est fixée de manière amovible sur la partie d'habillage (4).

4. Ensemble d'étanchéité selon la revendication 2 ou 3,
***caractérisé en ce que*** la fermeture (10) est perforée au niveau des chambres (5, 6) de répartition d'air.

5. Ensemble d'étanchéité selon l'une quelconque des revendications 2 à 4,
***caractérisé en ce que*** la fermeture (10) est conformée en composant pour blindage électromagnétique et/ou est munie d'éléments d'étanchéité à blindage électromagnétique.

6. Ensemble d'étanchéité selon l'une quelconque des revendications 2 à 3,
***caractérisé en ce que*** la fermeture (10) peut être fixée sur des barres (15) de fixation qui sont placées horizontalement et verticalement sur la partie d'habillage (4).

7. Ensemble d'étanchéité selon l'une quelconque des revendications précédentes,
***caractérisé en ce que*** les cadres d'étanchéité (12, 14) dépassent quasi perpendiculairement de la partie de fixation (2) ou bien de la partie d'habillage (4) et présentent un bord d'étanchéité (20) qui va pratiquement jusqu'à la fermeture (10).

8. Ensemble d'étanchéité selon la revendication 7,
***caractérisé en ce que*** les joints (22, 24) sont appliqués sur les cadres d'étanchéité (12,14) ou de manière complémentaire aux cadres d'étanchéité (12, 14) sur la face intérieure ou bien extérieure de la fermeture (10).

9. Ensemble d'étanchéité selon la revendication 8,
***caractérisé en ce que*** les joints (22, 24) sont des profilés d'étanchéité, par exemple des joints à lèvres, qui sont tenus de manière amovible sur les cadres d'étanchéité (12, 14) ou sur la fermeture (10).

10. Ensemble d'étanchéité selon la revendication 8,
***caractérisé en ce que***, comme joints (22, 24), de la mousse de polyuréthane est appliquée directement par extrusion sur la fermeture (10) et un joint sans fin est formé au terme d'une opération de moussage.

11. Ensemble d'étanchéité selon l'une quelconque des revendications 6 à 10,
***caractéri-sé en ce que*** les barres de fixation (15) de la partie d'habillage (4) sont réalisées avec une section transversale en U et le cadre d'étanchéité (14) est intégré dans les barres de fixation (15).

12. Ensemble d'étanchéité selon la revendication 11,
***caractérisé en ce que*** les barres de fixation (15) comportent à l'extérieur une bride de fixation (16) qui s'étend parallèlement au battant (25) de porte et à la fermeture (10), et ***en ce que*** la fermeture (10) et l'appareil de climatisation (7) peuvent être fixés sur la bride de fixation (16).

13. Ensemble d'étanchéité selon la revendication 12,
***caractérisé en ce que*** l'appareil de climatisation (7) peut être fixé sur les barres de fixation (15) de la partie d'habillage (4) à l'aide d'un cadre de fixation (11).

14. Ensemble d'étanchéité selon l'une quelconque des revendications précédentes,
***caractérisé en ce que*** le cadre d'étanchéité (12) est intégré dans la partie de fixation (2) de l'appareil de climatisation (7).
